Europäisches Patentamt

European Patent Office

Office européen des brevets

(11) Publication number: **0 100 145**
**A2**

## EUROPEAN PATENT APPLICATION

(21) Application number: **83303604.9**

(22) Date of filing: **22.06.83**

(51) Int. Cl.³: **H 03 H 11/12, H 03 H 11/28**

(30) Priority: **22.07.82 CA 407804**

(71) Applicant: **NORTHERN TELECOM LIMITED, 1600 Dorchester Boulevard West, Montreal Quebec H3H 1R1 (CA)**

(43) Date of publication of application: **08.02.84**
**Bulletin 84/6**

(72) Inventor: **Taralp, Guner, 1375 Prince of Wales Drive Apt. 2308, Ottawa Ontario K2C 3L5 (CA)**
Inventor: **van de Puije, Patrick David, R.R. No. 2, North Gower Ontario, K0A 2TO (CA)**

(74) Representative: **Crawford, Andrew Birkby et al, A.A. THORNTON & CO. Northumberland House 303-306 High Holborn, London WC1V 7LE (GB)**

(84) Designated Contracting States: **DE FR GB NL SE**

(54) Electrical filter comprising resonant circuits.

(57) A filter, such as a bandpass filter for use at intermediate frequencies in a radio transmission system, includes at least one filter stage comprising a common-emitter transistor (1) having resonant circuits (4, 5) in both its collector and emitter circuits. The ratio of the impedances of the resonant circuits (4, 5) determines the frequency response of the filter. The resonant circuits (4, 5) are isolated from one another by the transistor (1) so that they can be individually tuned. The presence of the transistor (1) also enables the input return loss of the filter to be determined independently of the tuning of the resonant circuits (4, 5). Individual filter stages can be cascaded.

ELECTRICAL FILTER COMPRISING RESONANT CIRCUITS

This invention relates to filters comprising resonant circuits.

It is known to provide a passive filter comprising resonant circuits between a resistive source and a resistive load. In such an arrangement the inductance and capacitance values used in the resonant circuits have a direct influence on the input impedance of the filter, which impedance must be matched to the source resistance in order to satisfy input return loss (reflection coefficient) requirements of the filter. Thus selection of the reactive components of the filter to provide a desired filter characteristic is limited by the requirement to provide a desired input return loss. In addition, in such a passive filter resistive losses, which may be desirable to provide particular filter characteristics, should be avoided.

This invention seeks to provide a filter comprising resonant circuits in which these limitations are avoided or substantially reduced.

According to one aspect of this invention there is provided a filter comprising first and second resonant circuits, transistor amplifying means having a controlled path connected in series between said resonant circuits, means for applying a signal to be filtered to an input of the transistor amplifying means, and means for deriving a filtered signal from an output of the transistor amplifying means, the resonant circuits together determining a frequency response of the filter.

In order to enhance the frequency response, a filter may comprise a plurality of cascaded filter stages each of which comprises a filter as recited above. Alternatively, the filter may include a further resonant circuit coupled to said output, and means for deriving a further filtered signal from an output of the further resonant circuit.

The transistor amplifying means preferably comprises a bipolar transistor connected in a common-emitter configuration with said first and second resonant circuits being connected respectively in collector and emitter circuits of the transistor.

According to another aspect, this invention provides a filter comprising a bipolar transistor, means for applying a signal to be filtered to the base of the transistor, a first resonant circuit connected in a collector circuit of the transistor, a second resonant circuit connected in an emitter circuit of the transistor, and means for deriving a filtered signal from the collector of the transistor, the ratio of the impedance of the first resonant circuit to that of the second resonant circuit determining a frequency response of the filter.

Conveniently the first resonant circuit comprises a parallel-resonant circuit comprising an inductance in parallel with a capacitance, and a resistance connected in parallel with the parallel-resonant circuit.

Preferably the second resonant circuit comprises at least one parallel-resonant circuit and a resistance connected in series therewith.

The use of parallel-resonant circuits and resistances facilitates biasing of the transistor and limits impedance variations in the circuits connected to the collector and emitter of the transistor, facilitating stable operation of the filter.

The invention will be further understood from the following description with reference to the accompanying drawings, in which:

Fig. 1 schematically illustrates a filter according to an embodiment of the invention;

3

Fig. 2 schematically illustrates, in more detail, a filter according to another embodiment of the invention;

Fig. 3 shows graphs illustrating the response of the filter of Fig. 2;

Fig. 4 schematically illustrates a filter comprising cascaded stages in accordance with a further embodiment of the invention;

Fig. 5 shows graphs illustrating the response of the filter of Fig. 4;

Fig. 6, which is on the same sheet as Fig. 4, schematically illustrates a filter according to yet another embodiment of the invention; and

Fig. 7 is a detailed circuit diagram of the filter of Fig. 6.

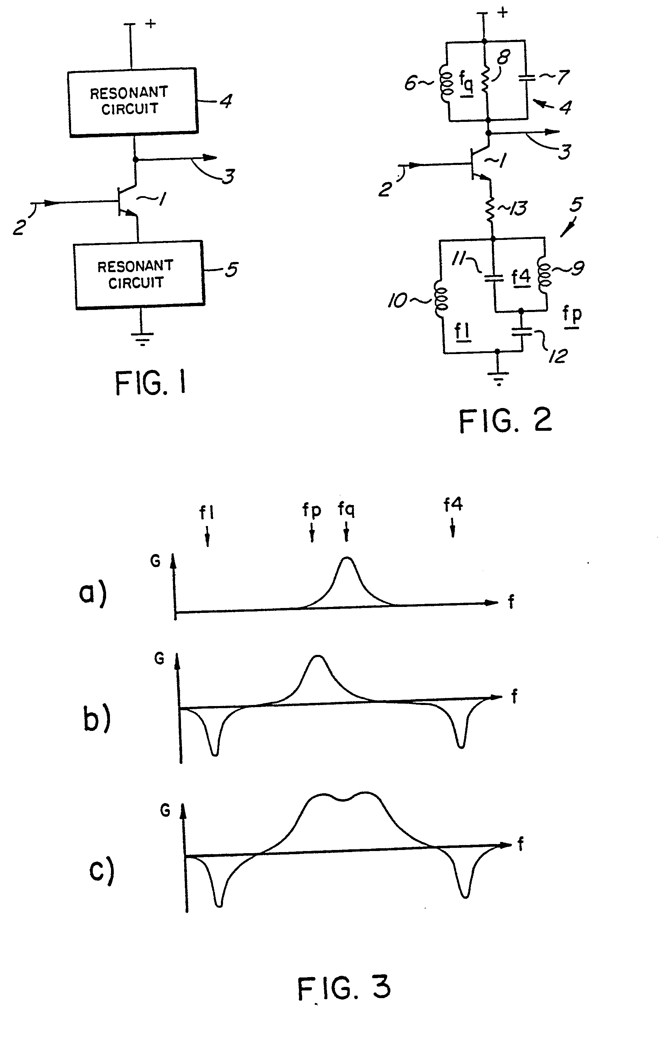

Referring to Fig. 1, a filter according to an embodiment of the invention comprises an NPN bipolar transistor 1 connected in a common-emitter amplifier configuration with an input 2 connected to its base and an output 3 connected to its collector, with its collector-emitter path connected in series between two resonant circuits 4 and 5. The gain of such a circuit is dependent upon the ratio of the impedance Zc of the resonant circuit 4 connected to the collector to the impedance Ze of the resonant circuit 5 connected to the emitter, each of which impedances is frequency-dependent so that the circuit constitutes a filter.

For example, if the circuit 4 is a parallel-resonant circuit having a high impedance Zc at its resonant frequency, the filter will have a high gain at this frequency. If the circuit 5 is a parallel-resonant circuit the filter will have a low gain, or high attenuation, at its

4

resonant frequency, whereas if the circuit 5 is a series-resonant circuit having a low impedance Ze at its resonant frequency, the filter will have a high gain at this frequency. The circuits 4 and 5 can be arbitrary resonant circuits of simple or complex form each having one or more resonant frequencies to provide arbitrary filter characteristics.

It should be noted that in the filter of Fig. 1 the resonant circuits 4 and 5 are isolated from one another by the collector-emitter path of the transistor 1, so that interaction between these circuits is substantially avoided thereby facilitating designing and tuning of the filter to provide a desired frequency response. Furthermore, the resonant circuits 4 and 5 are relatively isolated from the input 2, so that the input return loss of the filter can be determined independently of the frequency response determination. These factors considerably ease the problems of designing and tuning for particular filter characteristics.

In order to provide stable operation of the filter of Fig. 1, the resonant circuits 4 and 5 should include resistive components to limit the range of impedance values to which the transistor 1 is subject, thereby limiting the Q of the resonant circuits. This also provides the advantage of enabling the filter to have a low ripple over a wide bandwidth.

Fig. 2 shows, in more detail, a filter similar to that of Fig. 1. The filter of Fig. 2 is a bandpass filter having a frequency response which is explained with reference to Fig. 3. In Fig. 2, the resonant circuit 4 is constituted by a parallel resonant circuit consisting of an inductor 6, a capacitor 7, and a resistor 8 having a resonant frequency fq. For a constant emitter circuit impedance Ze, this resonant circuit 4 would provide the filter of Fig. 2 with a frequency response as shown in graph (a) of Fig. 3, in which gain G is plotted as a function of frequency f.

The resonant circuit 5 in Fig. 2 is constituted by two parallel resonant circuits and one series resonant circuit constituted by inductors 9 and 10, capacitors 11 and 12, and a series resistor 13. The inductor 9 is parallel resonant with the capacitor 11 at a frequency f4, and these components are series resonant with the capacitor 12 at a frequency fp. The capacitor 12 is parallel resonant with the inductor 10 at a frequency f1, at which frequency the effect of the inductor 9 and capacitor 11 is negligible. For a constant collector circuit impedance Zc, this resonant circuit 5 would provide the filter of Fig. 2 with a frequency response as shown in graph (b) of Fig. 3.

As the resonant circuits 4 and 5 are both present in the filter of Fig. 2, the overall filter characteristic is a combination of the frequency responses shown in graphs (a) and (b) of Fig. 3, as shown in graph (c) of Fig. 3. As should be appreciated, this is a bandpass filter characteristic.

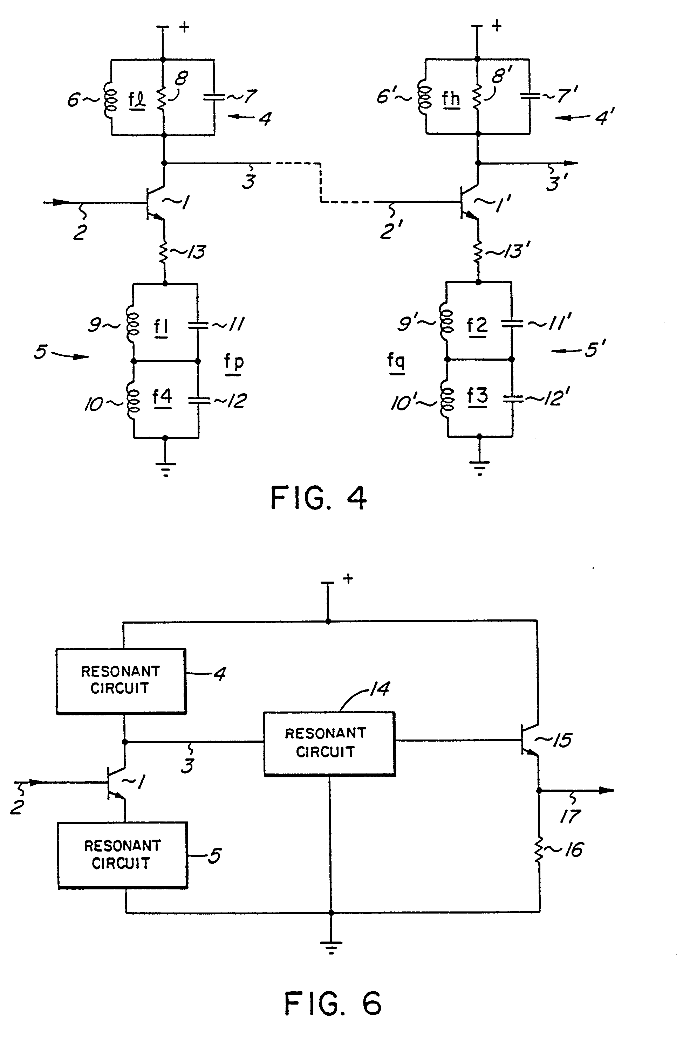

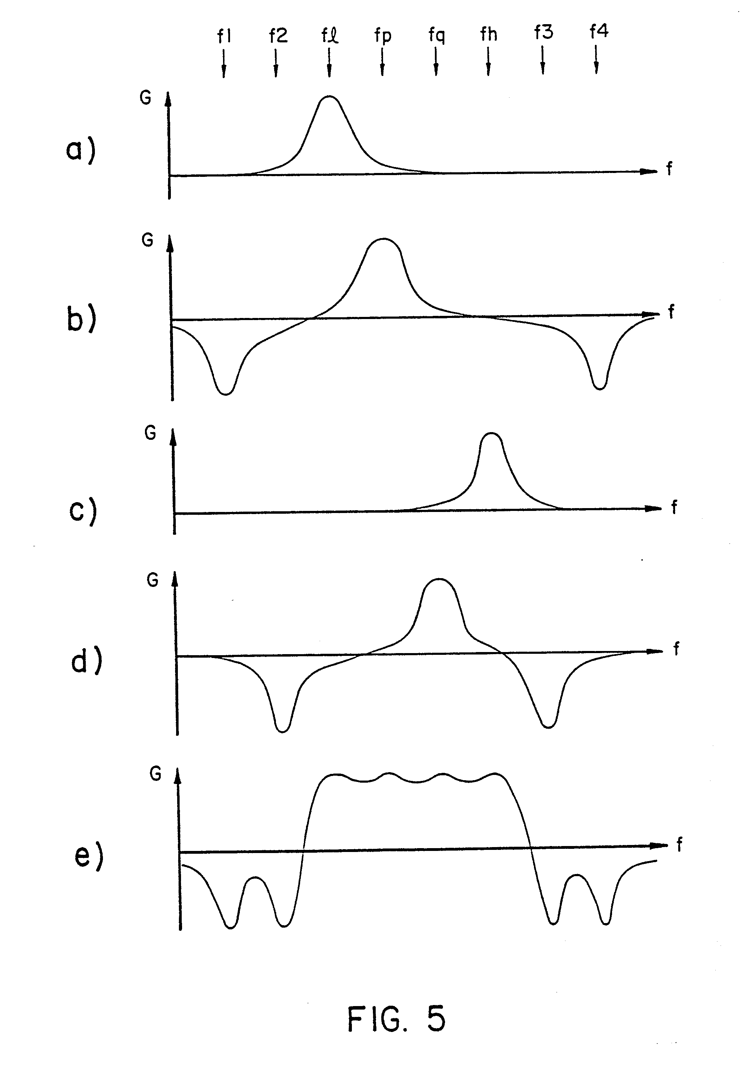

Fig. 4 illustrates two cascaded filter stages each of which is similar to the filter of Fig. 2, except for the resonant frequencies and a slightly different, but equivalent, arrangement of the resonant circuit 5. Accordingly, the same references as in Fig. 2 are used in Fig. 4, with primed references being used for the second stage. In the same manner as in Fig. 3, Fig. 5 illustrates the frequency response provided by the filter of Fig. 4, graphs (a) to (d) in Fig. 5 denoting respectively the contributions of the resonant circuits 4, 5, 4', and 5'. Graph (e) in Fig. 5 shows the composite bandpass filter characteristic of the filter of Fig. 4.

6

Tuning the filter of Fig. 4 is particularly easy, as a result of the isolation of the various resonant circuits. Thus the resistors 8, 13, 8', and 13' may be adjusted to accentuate the stop-band nulls and the pass-band ripple, and the resonant circuits tuned individually to their respective frequencies. The resistors can then be adjusted to decrease the pass-band ripple to the desired level. Further cascaded filter stages can be added as desired to provide a higher order filter and improved performance, this being particularly easy and convenient because all of the stages have the same form.

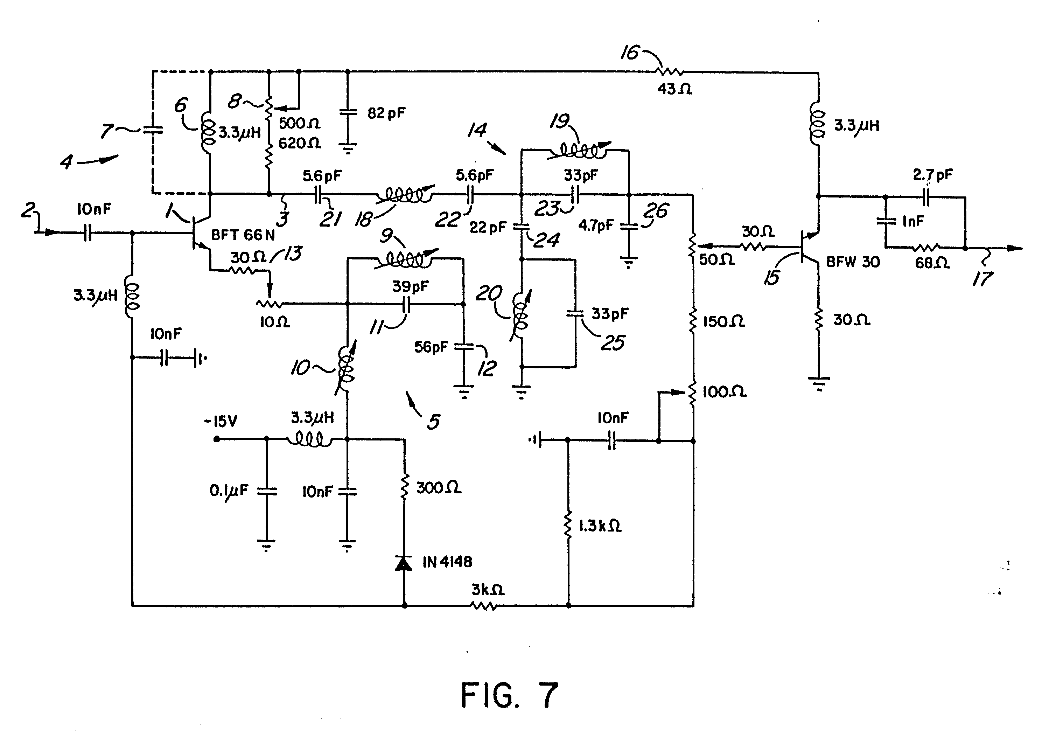

An alternative form of filter for achieving a filter characteristic such as that shown in Fig. 5(e) is shown in Fig. 6, in which the second stage of the filter of Fig. 4 is replaced by a resonant circuit 14 which couples the output 3 of the first stage to a buffer amplifier, constituted by common-collector transistor 15 and a resistor 16, having an output 17. The resonant circuit 14 in the filter of Fig. 6 provides a similar frequency response to that provided by the second stage of the filter of Fig. 4, but avoids the need for the second transistor 1' in the filter itself.

Fig. 7 illustrates in detail the circuit diagram of the filter of Fig. 6. In Fig. 7 the same references as used above are used to denote similar components.

The filter of Fig. 7 is intended for use as an intermediate frequency (I.F.) filter in a radio transmission system having an I.F. of 70MHz, the filter providing a pass-band which is flat within 1dB from 48 to 92MHz. The collector-emitter paths of the transistors 1 and 15 of the filter are connected in series with one another for d.c. biasing, the biasing arrangements of the transistors being illustrated in Fig. 7 but not being described below.

In the filter of Fig. 7, the resonant circuit 4 is a low-Q circuit which is constituted by the inductor 6, resistor 8, and capacitor 7 connected in parallel as in Fig. 2, the circuit being resonant at the I.F. of 70MHz. However, in this filter the capacitor 7 is constituted by stray capacitance of the circuit, and hence is shown in broken lines in Fig. 7. The low-Q of this circuit facilitates providing the desired broad bandwidth of the filter.

The resonant circuit 5 in Fig. 7 is similar to that shown in Fig. 2, comprising the elements 9 to 13. The inductor 9 and capacitor 11 are tuned to be parallel resonant at 115MHz, corresponding to the frequency f4 in Fig. 5, and the inductor 10 and capacitor 12 are tuned to be parallel resonant at 30MHz, corresponding to the frequency f1 in Fig. 5.

The resonant circuit 14 in Fig. 7 comprises inductors 18, 19, and 20 and capacitors 21 to 25. The inductor 18 and capacitors 21 and 22 couple the output 3 of the first stage of the filter to a shunt series-resonant circuit formed by the inductor 20 and the capacitor 24, and to a series parallel-resonant circuit formed by the inductor 19 and the capacitor 23. The series-resonant circuit 20, 24 is resonant at 40MHz, corresponding to the frequency f2 in Fig. 5, the filter notch provided by this circuit being sharpened by the capacitor 25, and the parallel-resonant circuit 19, 23 is resonant at 100MHz, corresponding to the frequency f3 in Fig. 5. In addition, the inductor 18 resonates with the capacitor 24, and the inductor 20 resonates with the capacitor 22, to enable the filter characteristic to be flattened in the pass-band at frequencies towards the band edges.

8

Although particular embodiments of the invention have been described, numerous changes may be made thereto within the scope of the invention. For example, although the above description relates particularly to bandpass filters using predominantly parallel resonant circuits to facilitate biasing the transistors, the various resonant circuits may be of arbitrary forms to provide any desired filter characteristics. In addition, although the described filters use bipolar transistors in a common emitter configuration, as is preferred to provide a relatively constant input impedance and to isolate the input from the resonant circuits, other transistor configurations and other types of transistor amplifying means may be provided instead. Accordingly the invention is not limited to the described embodiments, except as defined by the following claims.

CLAIMS

1. A filter comprising transistor amplifying means and first and second resonant circuits together determining a frequency response of the filter, characterized in that the transistor amplifying means (1) has a controlled path connected in series between said resonant circuits (4, 5), the filter including means (2) for applying a signal to be filtered to an input of the transistor amplifying means (1), and means (3) for deriving a filtered signal from an output of the transistor amplifying means (1).

2. A filter as claimed in claim 1 characterized by including a further resonant circuit (14) coupled to said output (3), and means (15, 17) for deriving a further filtered signal from an output of the further resonant circuit (14) (Fig. 6).

3. A filter as claimed in claim 1 or 2 characterized in that the transistor amplifying means (1) comprises a bipolar transistor (1) connected in a common-emitter configuration with said first and second resonant circuits (4, 5) being connected respectively in collector and emitter circuits of the transistor (1).

4. A filter comprising a bipolar transistor, means for supplying a signal to be filtered to the base of the transistor, a first resonant circuit connected in a collector circuit of the transistor, and means for deriving a filtered signal from the collector of the transistor, <u>characterized by</u> a second resonant circuit (5) connected in an emitter circuit of the transistor (1), the ratio of the impedance of the first resonant circuit (4) to that of the second resonant circuit (5) determining a frequency response of the filter.

5.   A filter as claimed in claim 4 <u>characterized in that</u> the first resonant circuit (4) comprises a parallel-resonant circuit comprising an inductance (6) in parallel with a capacitance (7), and a resistance (8) connected in parallel with the parallel-resonant circuit, the capacitance (7) of the first resonant circuit (4) being constituted by stray capacitance.

6.   A filter as claimed in claim 4 or 5 <u>characterized in that</u> the second resonant circuit (5) comprises at least one parallel-resonant circuit (9 and 11, 10 and 12) and a resistance (13) connected in series therewith.

7.   A filter comprising a plurality of cascaded filter stages, <u>characterized in that</u> each filter stage comprises a filter as claimed in any of claims 1 to 6.

8.   A filter as claimed in claim 5 or 6 <u>characterized by</u> including a further resonant circuit (14) coupled to the collector of the transistor (1), and means (15, 17) for deriving a further filtered signal from an output of the further resonant circuit (14).

9.    A filter as claimed in claim 8 <u>characterized in that</u> the further resonant circuit (14) comprises a shunt-connected series-resonant circuit (20, 24), a parallel-resonant circuit (19, 23) coupled in series between the shunt-connected series-resonant circuit (20, 24) and the means (15, 17) for deriving the further filtered signal, and a coupling network (18, 21, 22) coupling the collector of the transistor (1) to the shunt-connected series-resonant circuit (20, 24) and the parallel-resonant circuit (19, 23) (Fig. 7).

10.    A filter as claimed in claim 9 <u>characterized in that</u> the coupling network (18, 21, 22) comprises reactive components (18, 22) which resonate with reactive components (24, 20 respectively) of the shunt-connected series-resonant circuit (20, 24).

11.    A filter as claimed in any of claims 1 to 10 <u>characterized in that</u> the resonant circuits (4, 5) provide the filter with a bandpass characteristic.

1/4

0100145

FIG. 1

FIG. 2

FIG. 3

0100145

FIG. 4

FIG. 6

0100145

FIG. 5

0100145

FIG. 7